# EUROPEAN PATENT APPLICATION

(11) **EP 4 832 335 A1**
(43) Date of publication of application: **28.10.2026**
(21) Application number: 24908020.1
(22) Date of filing: 17.12.2024
(51) Int. Cl.: H02N 2/18, H02N 11/00, H10N 30/30

(54) **ENERGY HARVESTING DEVICE**

(30) Priority: 18.12.2023 KR 20230185221
(71) Applicant: POSCO Holdings Inc., Pohang-si, Gyeongsangbuk-do 37859 (KR); POSTECH Research and Business Development Foundation, Pohang-si, Gyeongsangbuk-do 37673 (KR); Research Institute of Industrial Science & Technology, Pohang-si, Gyeongsangbuk-do 37673 (KR)
(72) Inventor: RHO, Jun-Suk, Pohang-si, Gyeongsangbuk-do 37673 (KR); PARK, Jeong-Hoon, Pohang-si, Gyeongsangbuk-do 37673 (KR); LEE, Geon, Pohang-si, Gyeongsangbuk-do 37673 (KR)
(74) Representative: Pfenning, Meinig & Partner mbB
(86) International application number: PCT/KR2024/020514
(87) International publication number: WO 2025/135737

(57) **Abstract**

One embodiment of the present invention provides an energy harvesting device comprising: a body; a plurality of unit pattern portions formed and arranged periodically on the body, each including a protrusion formed to protrude in one direction from a surface of the body and a through-hole formed to penetrate the body along the one direction; a defect portion disposed on the body and formed at a position adjacent to some of the plurality of unit pattern portions; and an energy conversion portion disposed in the defect portion.

## Description

### Technical Field

The present disclosure relates to an energy harvesting device based on elastic metamaterial.

### Background Art

The recent rapid development of low-power electronic device technology has miniaturized various electrical devices and made it possible for these devices to operate in low-power situations of microwatts. Specifically, the miniaturization of environmental diagnosis sensors for buildings or bridges, safety diagnosis sensors for mechanical structures such as ships and aircraft, sensors for home automation systems, and various types of sensors have enabled more effective and constant sensor operation by inserting sensors into these structures from the time of construction thereof and configuring a wireless network. The constant monitoring system of such a wireless sensor network requires a power supply system for each sensor node. Batteries may be used in such a power supply method, but such batteries have the disadvantage of short operating lifespan. Replacing the battery is impossible or significantly inefficient because sensors in the wireless sensor network need to be inserted into the structure. As a solution to this problem, an energy harvesting method has been developed to generate and supply power from surrounding energy sources.

Some of the most well-known energy harvesting methods include a method of generating power from solar energy using solar cells, a method of generating power from thermal energy using the Seebeck effect, and a method of generating power from vibrational energy using electromagnetic induction (Faraday's law of electromagnetic induction), electrostatic effects, piezoelectric effects, or magnetostriction effects. Among these methods, when a defect-based energy harvesting device applies a wave at a frequency corresponding to a defect band, the defect may resonate in a specific defect mode shape, while causing the wave energy to be localized near the defect, thereby improving energy harvesting performance.

On the other hand, metamaterials are materials that may realize previously unobserved bizarre wave phenomena by periodically arranging artificially designed unit structures, and depending on the relationship between the arrangement periodicity and the operating wavelength, such metamaterials may be used for various purposes, such as wave refraction, aggregation, and reflection, particularly for controlling elastic waves, among various waves.

However, due to limitations such as design complexity and limited structure size, conventional elastic metamaterials have been researched and developed a lot for wave control limited to the high-frequency domain. In particular, studies have been actively conducted to improve the performance of piezoelectric energy harvesting, which converts elastic wave energy into electrical energy using wave aggregation, but research on piezoelectric energy harvesting using existing metamaterials was limited to the high-frequency domain and had limitations in being applied in real lifespan.

### Disclosure of Invention

### Technical Problem

The present invention has been devised to solve the above-mentioned problems, and aims to provide an energy harvesting device which may harvest electrical energy in the low-frequency region as well as the high-frequency region by forming a band gap having an extended region, simultaneously in the low-frequency and high-frequency bands.

### Solution to Problem

In order to achieve the above-described purpose, an energy harvesting device according to an embodiment of the present disclosure may include: a body; a plurality of unit pattern portions formed and arranged periodically on the body, each including a protrusion portion formed to protrude in one direction from a surface of the body, and a penetration portion formed to penetrate the body in the one direction; a defect portion disposed on the body, and formed in a position adjacent to portions of the plurality of unit pattern portions; and an energy conversion portion disposed in the defect portion.

In an embodiment of the present disclosure, the unit pattern portion may have a shape in which, based on the protrusion portion, a plurality of penetration portions surround the protrusion portion but are spaced apart from each other.

In an embodiment of the present disclosure, a plurality of the unit pattern portions may be arranged in a grid shape on the body.

In an embodiment of the present disclosure, the defect portion (P20) may be surrounded by the plurality of unit pattern portions and may be a region in which the protrusion portion is not formed.

In an embodiment of the present disclosure, in the defect portion (P20), a first band gap in a first frequency band may be generated by local resonance induced by the protrusion portion, and a second band gap in a second frequency band may be generated by periodicity of the penetration portion.

In an embodiment of the present disclosure, the second frequency band may be a higher frequency band than the first frequency band.

In an embodiment of the present disclosure, the first band gap and the second band gap may be generated simultaneously.

In an embodiment of the present disclosure, when the band gap is generated, a region of the first band gap and a region of the second band gap may be expanded due to interaction between the protrusion portion and the penetration portion.

In an embodiment of the present disclosure, the protrusion portion may be in the form of a cylindrical projection, and the penetration portion may be in the form of a penetration hole having a circular cross-section.

In an embodiment of the present disclosure, the protrusion portion and the penetration portion may have the same diameter.

In an embodiment of the present disclosure, the energy conversion portion may include a piezoelectric element.

In an embodiment of the present disclosure, the body may be formed of an elastic metamaterial.

### Advantageous Effects of Invention

As described above, the energy harvesting device according to example embodiments of the present invention may form a band gap having an expanded region, simultaneously in the low-frequency band and the high-frequency band, by periodically forming a plurality of protrusion portions and a plurality of penetration portions on an object, utilizing local resonance induced by the protrusion portions and Bragg scattering generated by the periodicity of the penetration portions. In addition, by destroying the periodicity of the unit pattern portion in a portion of the object to form a defect state, elastic wave energy may be concentrated at the defect portion and converted into electrical energy, thereby improving the energy harvesting performance of the energy harvesting device. Accordingly, the limitations of the high-performance piezoelectric energy harvesting device, which were limited to the high-frequency range, may be overcome, so that the energy harvesting device may be implemented in the low-frequency range as well, for application in real life. Accordingly, the limitations of the high-performance piezoelectric energy harvesting device, which were limited to the high-frequency range, may be overcome, so that the energy harvesting device may be implemented in the low-frequency range as well, for application in real life.

### Brief Description of Drawings

FIG. 1 is a perspective view illustrating a portion of an energy harvesting device according to an embodiment of the present invention.
FIG. 2 is a plan view illustrating the energy harvesting device of FIG. 1 viewed from the top.
FIG. 3 is a perspective view illustrating a unit pattern portion forming an energy harvesting device according to an embodiment of the present invention.
FIG. 4 is a perspective view illustrating a state in which an energy conversion portion is connected to a defect portion (P20), in an energy harvesting device according to an embodiment of the present invention.
FIG. 5a is a graph illustrating an energy band gap in an energy harvesting device equipped only with a protrusion portion.
FIG. 5b is a graph illustrating an energy band gap in an energy harvesting device equipped only with a penetration portion.
FIG. 5c is a graph illustrating an energy band gap in an energy harvesting device according to the present invention, which includes both a protrusion portion and a penetration portion;
FIG. 6a is a view illustrating a defect band structure of an energy harvesting device according to the present invention.
FIG. 6b is a view illustrating an example of a defect mode shape of an energy harvesting device according to the present invention.
FIG. 7a is an example illustrating a state in which an input portion is connected to an energy harvesting device according to the present invention.
FIG. 7b is an example illustrating that elastic energy is concentrated at a coupling portion.
FIGS. 8a and 8b are graphs illustrating an example of an energy conversion result at a defect portion in a low-frequency band.
FIGS. 9a and 9b are graphs illustrating an example of an energy conversion result at a defect portion in a high-frequency band.

### Best Mode for the Invention

Hereinafter, preferred example embodiments will be described in detail with reference to the accompanying drawings so that those of ordinary skill in the art may easily implement the present disclosure. However, in describing preferred embodiments of the present disclosure in detail, when it is determined that a detailed description of related known functions or configurations may unnecessarily obscure the gist of the present disclosure, the detailed description thereof will be omitted. Furthermore, the same reference numbers are used throughout the drawings to refer to the same or similar functions and actions. In addition, in this specification, the expressions such as "on," "above," "upper," "below," "beneath," "lower," and "side surface," are merely indicated based on drawings, and may actually vary depending on the direction in which the components are disposed.

Furthermore, throughout the specification, the terms "connected to" or "coupled to" are used to designate a connection or coupling of one element to another element and include both a case where an element is "directly connected or coupled to" another element and a case where an element is "indirectly connected or coupled to" another element via still another element. Furthermore, when a certain portion "includes" or "comprises" a certain component, this indicates that other components are not excluded and may be further included unless otherwise noted.

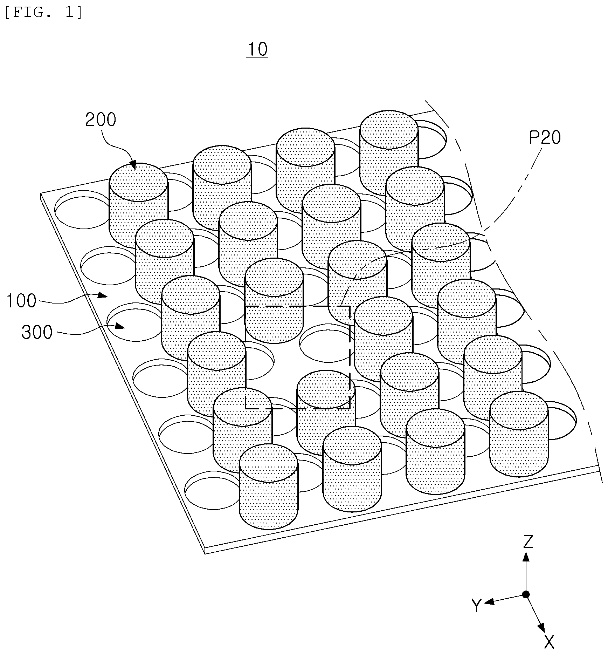

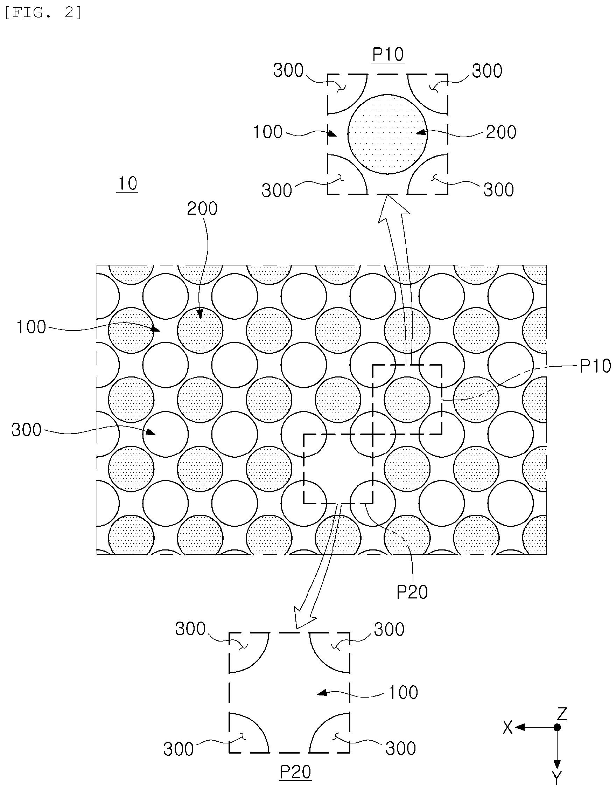

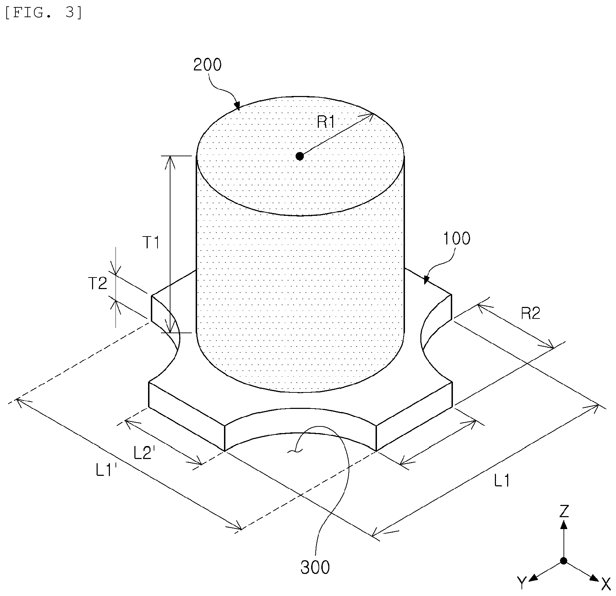

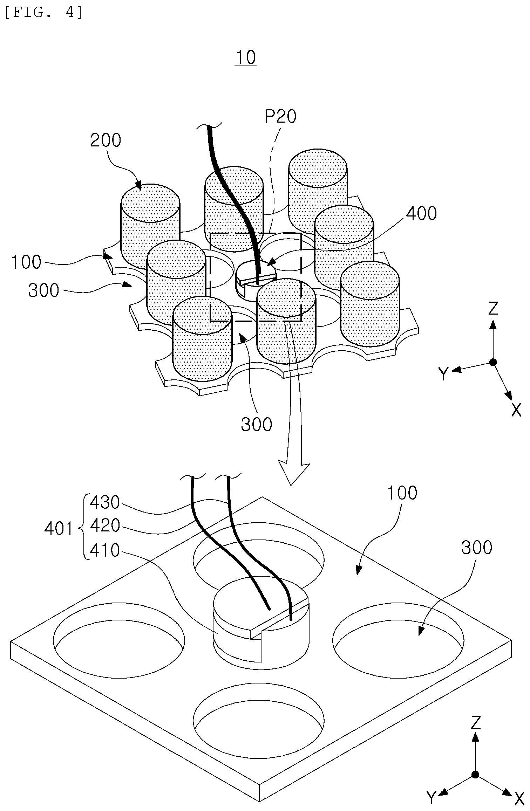

FIG. 1 is a perspective view illustrating a portion of an energy harvesting device according to an embodiment of the present invention. FIG. 2 is a plan view illustrating the energy harvesting device of FIG. 1 viewed from the top. FIG. 3 is a perspective view illustrating a unit pattern portion forming an energy harvesting device according to an embodiment of the present invention. Additionally, FIG. 4 is a perspective view illustrating a state in which an energy conversion portion is connected to a defect portion (P20), in an energy harvesting device according to an embodiment of the present invention.

Referring to FIG. 1 to FIG. 4, an energy harvesting device (10) may include a body (100) and a unit pattern portion (P10) formed by including a protrusion portion (200). A plurality of such unit pattern portions (P10) may be provided. In this case, the energy harvesting device (10) may further include a defect portion (P20).

The body (100) is a portion in which other components of the energy harvesting device (10) are disposed, and may be in the form of a thin plate.

The protrusion portion (200) may be disposed on the body (100). The protrusion portion (200) may be formed to protrude in a direction (Z) toward the outside from an upper surface of the body (100). In this case, the protrusion portion (200) may have various shapes. For example, the protrusion portion (200) may be in the shape of a cylinder. Meanwhile, the present invention is not limited thereto, but the following description will focus on an embodiment in which the protrusion portion (200) is in the shape of a cylinder having a first radius (R1).

A protruding length (hereinafter referred to as a protrusion portion length) (T1) of the protrusion portion (200) may differ from a thickness (T2) of the body (100). For example, the protrusion portion length (T1) of the protrusion portion (200) may be formed to be larger than the thickness (T2) of the body (100).

The penetration portion (300) may be a hole formed by penetrating through the body (100) in one direction. Here, the one direction may be a direction parallel to the thickness direction (Z) of the penetration portion (300). The penetration portion (300) may have a cross-section of various shapes. For example, the penetration portion (300) may be in the form of a penetration portion having a circular cross-section. Meanwhile, the present invention is not limited thereto, but the following description focuses on an embodiment in which the penetration portion (300) is a circular hole having a second radius (R2).

As described above, in the case of a cylindrical protrusion portion (200) and a circular hole having a circular cross-section, the radius (R1) of the protrusion portion (200) (hereinafter referred to as the first radius) and the radius (R2) of the penetration portion (300) (hereinafter referred to as the second radius) may be the same or similar in size.

The unit pattern portion (P10) is a partial region of the body (100), and within the partial region, at least one protrusion portion (200) and at least one penetration portion (300) may be formed by being arranged in a predetermined pattern.

In an embodiment, the unit pattern portion (P10) may be in a form in which a plurality of penetration portions (300) are arranged to surround one protrusion portion (200). In this case, a single unit pattern portion (P10) may be formed so that the plurality of penetration portions (300) surround the protrusion portion (200) disposed in the center of the unit pattern portion (P10), as illustrated exemplarily in FIG. 3. In this case, when viewed from the top, the unit pattern portion (P10) may be in the shape of a square having a protrusion portion (200) disposed in the center thereof.

For example, the unit pattern portion (P10) may be in the shape of a square in which a length (L1) and a width (L1') are equal to. In this case, the penetration portions (300) included in the unit pattern portion (P10) may be spaced apart from each other by equal intervals in all directions. More specifically, a gap (L2) by which the penetration portions (300) are spaced apart from each other in a length direction (Y) and a gap (L2') by which the penetration portions (300) are spaced apart from each other in a width direction (X) may be equal to each other. As another example, the unit pattern portion (P10) may be in the shape of a rectangle having different lengths (L1) and widths (L1'). In this case, the gap (L2) by which the penetration portions (300) are spaced from each other in the length direction (Y) and the gap (L2') by which the penetration portions (300) are spaced from each other in the width direction (X) may be different from each other. However, for convenience of explanation, the following description will focus on a case in which the unit pattern portion (P10) is in the shape of a square.

The width (L1') and length (L1) of the unit pattern portion (P10) having a square cross-section [hereinafter referred to as the lengths (L1, L1') of the unit pattern portion] may be larger than a diameter of the penetration portion (300). More specifically, the penetration portions (300) adjacent to each other may be spaced apart from each other by predetermined gaps (L2, L2'). Accordingly, the lengths (L1, L1') of the unit pattern portion (P10) may have a size larger than the diameter of the penetration portion (300) by the aforementioned gaps (L2, L2').

A plurality of unit pattern portions (P10) may be provided. The plurality of unit pattern portions (P10) may be arranged continuously over an entire area of the body (100). In this case, the number of unit pattern portions (P10) is not limited. As arranged in this manner, a protrusion portion pattern in which a plurality of protrusion portions (200) are arranged in a grid shape and a penetration portion pattern in which a plurality of penetration portions (300) are arranged in a grid shape between the protrusion portions (200) may be simultaneously formed on the body (100). Accordingly, as the plurality of unit pattern portions (P10) are arranged in a grid shape, periodicity including the protrusion portion pattern and the penetration portion pattern may be formed on the body (100).

That is, the body (100) may be formed of an elastic metamaterial in which the unit pattern portions (P10), which are in the form of unit cells as described above, are periodically formed. Additionally, the body (100) may be formed of a material having elasticity, and accordingly, the body (100) may be formed of an elastic metamaterial.

The defect portion (P20) may be disposed adjacently to portions of the plurality of unit pattern portions (P10), on the upper surface of the body (100) as described above. More specifically, the defect portion (P20) may be a region surrounded by portions of the unit pattern portions (P10), among the plurality of unit pattern portions (P10) arranged in a grid shape, and may be a region in which the protrusion portion (200) [or the protrusion portion (200) and the penetration portion (300)] are not formed. Accordingly, the defect portion (P20) may be a unit region in which only the body (100) exists between the plurality of unit pattern portions (P10) arranged in a grid shape. Although the defect portions (P20) may be provided in plural, for the sake of convenience of explanation, the following description will focus on an embodiment in which only one defect portion (P20) is formed.

The defect portion (P20) may be formed to have the same size as the unit pattern portion (P10). An energy conversion portion (400), which will be described below, may be disposed in the defect portion (P20). Due to the defect portion (P20), a region (hereinafter referred to as a defect region) in which the periodicity formed by the unit pattern portions (P10) is locally destroyed may be formed in the body (100).

The energy conversion portion (400) may be comprised of an energy conversion element, which may be an element that has the effect of generating voltage when deformed by stress. The energy conversion portion (400) may be disposed within the defect portion (i.e., defect area) (P20) as described above.

For example, the energy conversion portion (400) may be comprised of a piezo element. In this case, the energy conversion portion (400) may be configured to include an energy conversion body (410) installed in the defect portion (P20), a pair of wire portions (420, 430) connected to the energy conversion body (410), and a power supply unit (not illustrated) electrically connected to the pair of wire portions (420, 430).

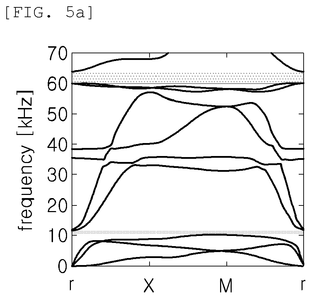

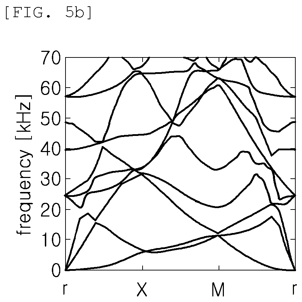

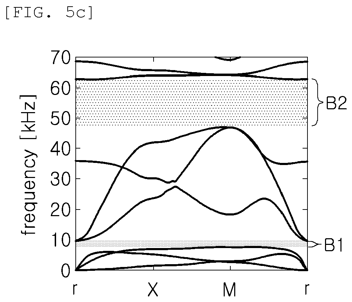

FIG. 5a is a graph illustrating an energy band gap in an energy harvesting device equipped only with a protrusion portion, FIG. 5b is a graph illustrating an energy band gap in an energy harvesting device equipped only with a penetration portion, and FIG. 5c is a graph illustrating an energy band gap in an energy harvesting device according to the present invention, which includes both a protrusion portion and a penetration portion.

Referring to FIG. 5a to 5c, the band gap, also known as a band space, a band interval, or an energy gap, refers to an energy level or an energy difference between the top of the highest energy band (valence band) occupied by electrons in a band structure of a semiconductor or an insulator and the bottom of the lowest space band (conduction band). Such a band gap is one of the representative wave singularities of an acoustic quantum crystal that does not allow waves of a specific frequency band to pass through.

In this case, a defect band may be generated within the band gap. The defect band refers to a band generated within the band gap, by replacing one of the unit pattern portions (P10) arranged to have periodicity on the body (100) with another form [i.e., a defect portion (P20)], and thus locally destroying the periodicity of the energy harvesting device (10). When a wave is applied at a frequency corresponding to such a defect band, energy may be localized by the mechanical resonance of the defect, and a single defect energy harvesting unit may be formed.

Meanwhile, in the case in which only a plurality of protrusion portions (200) are provided on the body (100) (hereinafter, Comparative Example 1), as illustrated in FIG. 5a, the protrusion portions (200) arranged in a grid form may cause local resonance, thereby forming a band gap in the low-frequency band. In addition, a band gap is formed in the high-frequency band due to Bragg scattering caused by the periodicity of the protrusion portions (200). However, in this case, according to the resonance-based single-frequency operating principle, a band gap is formed in a significantly narrow frequency range, and there is a limit to the formation of a defect state. In addition, when only a plurality of penetration portions (300) are provided in the body (100) (hereinafter, Comparative Example 2), it may be confirmed that no band gap region is formed, as illustrated in FIG. 5b.

In comparison, when both a protrusion portion (200) and a penetration portion (300) are provided, as in the energy harvesting device (10) according to the present invention, band gaps may be formed simultaneously in the low frequency band and the high frequency band, as illustrated in FIG. 5c. In this case, a band gap generated in the first frequency band is referred to as a first band gap (B1), and a band gap generated in the second frequency band is referred to as a second band gap (B2). In this case, a second frequency band may be a high frequency band, and a first frequency band may be a frequency band lower than the second frequency band, i.e., a low frequency band.

As described above, the first band gap (B1) and the second band gap (B2) formed may be formed as a more expanded region, as compared to Comparative Example 1. This is due to mutual interaction during the formation process of each band gap (B1, B2). For example, in the case of the low frequency band, the first band gap (B1) is formed as a region expanded by approximately 30%, as compared to Comparative Example 1, and in the case of the high frequency band, the second band gap (B2) is formed as a region expanded by approximately 420%, as compared to Comparative Example 1. In this manner, as the band gaps having expanded regions are formed in the low frequency band and the high frequency band, respectively, a defect state may be formed more easily as compared to the comparative examples.

Meanwhile, the relationship between frequency and wavelength (i.e., dispersion relation), as illustrated in FIG. 5a to FIG. 5c, may be derived by applying the Floquet-Bloch theory, which is an infinite period boundary condition, to the elastic wave governing equation. This dispersion relation is significantly decisive for understanding the propagation characteristics of waves within a medium and should be derived prior to deriving the band gap region. Once the dispersion relation is derived, a band gap may be generated within a certain frequency range based on Bragg scattering.

Furthermore, referring again to FIG. 5c, it may be observed that an inclination of the graph in each frequency band in which the first band gap (B1) and the second band gap (B2) are formed converges to O. In this case, the inclination of the graph represents the speed of the wave, and the convergence of such inclination to O means that the speed of the wave converges to 0. Accordingly, since the wave velocity converges to zero in both the first band gap region and the second band gap (B2) region, the elastic wave may not move and may be aggregated in the defect portion (P20). As the wave aggregates at the defect portion (P20) in this manner, this may induce a greater strain field in the energy conversion portion (400) comprised of a piezoelectric element, thereby improving the piezoelectric energy harvesting performance.

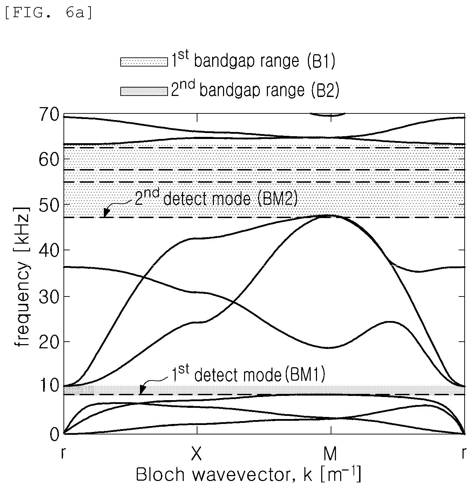

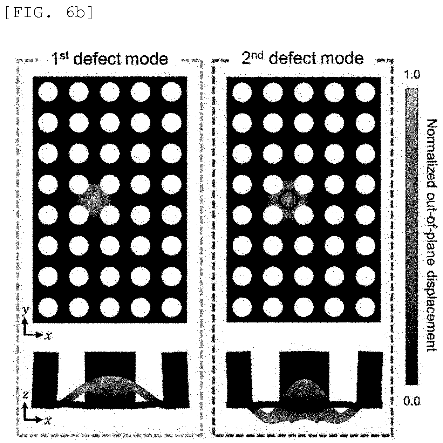

FIG. 6a is a view illustrating a defect band structure of an energy harvesting device according to the present invention, and FIG. 6b is a view illustrating an example of a defect mode shape of an energy harvesting device according to the present invention.

Referring to FIG. 6a, when examining the defect band structure of the energy harvesting device (10) according to the present invention, as seen in FIG. 5c above, it may be confirmed that both the first band gap (B1) formed in the low-frequency region and the second band gap (B2) formed in the high-frequency region have a defect state formed by the defect portion (P20).

Additionally, referring to FIG. 6b, when examining a defect mode shape of the energy harvesting device according to the present invention, it may be seen that in both defect states, elastic waves are aggregated in a bonding portion. The elastic wave energy in the form of a plane wave input to the energy harvesting device (10) propagates through the body (100). In this case, due to the protrusion portions (200) and penetration portions (300) arranged to have periodicity on the body (100), a phenomenon (band gap) occurs in which the propagation of the aforementioned elastic wave is obstructed. Accordingly, the elastic wave moves to the defect portion (P20), which is a region in which periodicity is destroyed on the body (100) and propagation is easy. Then, the elastic wave energy propagated into the defect portion (P20) is trapped within the defect portion (P20) as the elastic wave energy is obstructed from escaping from the defect portion (P20) by the unit pattern portion (P10) formed around the defect portion (P20). Due to the trapping and resonance phenomena of these elastic waves, elastic wave energy may be concentrated at the defect portion (P20), as exemplarily illustrated in FIG. 6b.

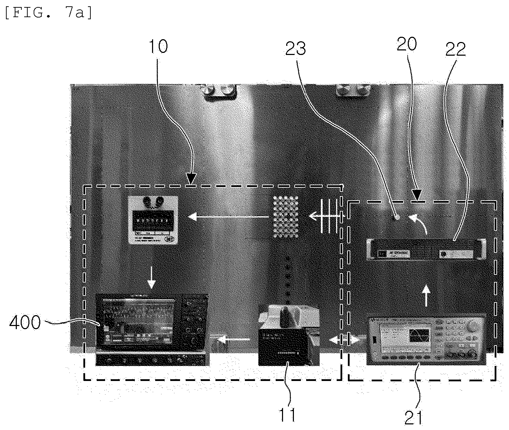

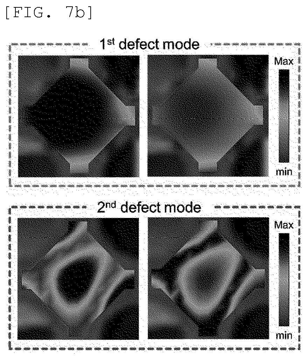

FIG. 7a is an example illustrating a state in which an input portion is connected to an energy harvesting device according to the present invention, and FIG. 7b is an example illustrating that elastic energy is concentrated at a coupling portion

Referring to FIG. 7a, an input unit (20) may be connected to the energy harvesting device (10) as described above. The input unit (20) may include a function generator (21), a power amplifier (22), and a transducer (23). In this case, when an electrical signal is input to the function generator (21), the electrical signal passes through the amplifier (22) to remove noise, and then is converted into an elastic wave at the transducer (23) and supplied to the energy harvesting device (10). Then, in a process of propagating through the body (100), the supplied elastic wave is concentrated at the defect portion (P10) as described above. The concentrated elastic wave energy may be converted (extracted) into electrical energy (voltage) by the energy conversion portion (400). In this case, a magnitude of the extracted voltage may be controlled, by adjusting a resistance value using a resistance substituter (12) prior to energy conversion.

Meanwhile, the energy concentrated at the defect portion (P20) may be detected by a detector (11), such as a scanning LDV. Accordingly, as illustrated exemplarily in FIG. 7b, it may be confirmed that elastic wave energy is concentrated at the defect portion (P20). For reference, an upper left diagram of FIG. 7b shows a maximum amplitude of the concentrated elastic wave in the first defect mode (BM1), and an upper right diagram of FIG. 7b shows a minimum amplitude of the concentrated elastic wave in the first defect mode (BM1). In addition, a lower left diagram of FIG. 7b shows when an amplitude of the aggregated elastic wave is at a maximum in the second defect mode (BM2), and a lower right diagram of FIG. 7b shows when the amplitude of the aggregated elastic wave is at a minimum in the second defect mode (BM2).

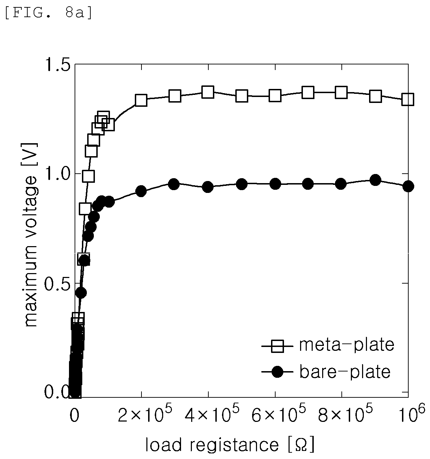

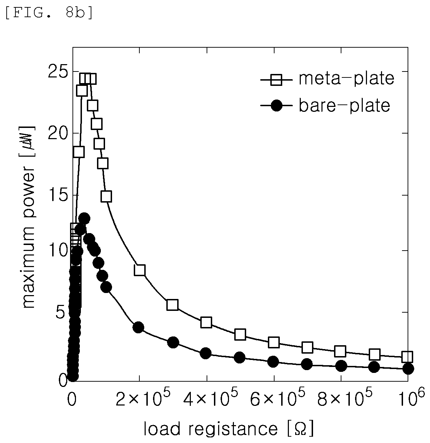

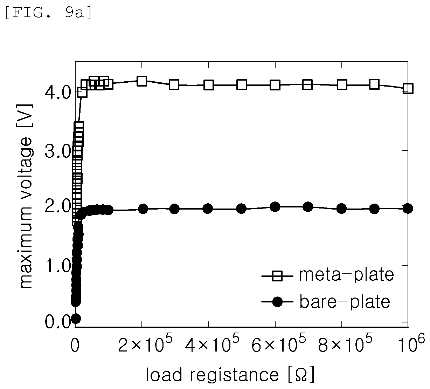

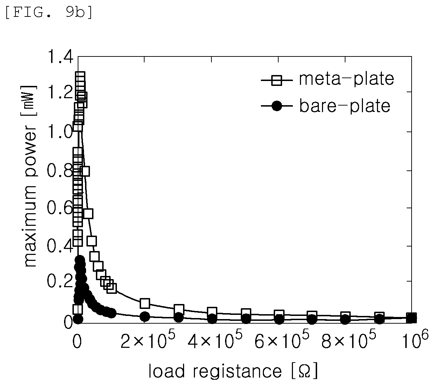

FIG. 8a and FIG. 8b are graphs showing an example of an energy conversion result at the defect portion (P20) in the low-frequency band. FIG. 9a and FIG. 9b are graphs showing an example of an energy conversion result at the defect portion (P20) in the high-frequency band.

As described above, an energy conversion portion (400) may be installed in the defect portion (P20). The energy conversion portion (400) may be comprised of a piezoelectric element and may convert elastic wave energy concentrated at the defect portion (P20) into electrical energy. In this case, as described above, since the body (100) is formed of an elastic metamaterial in which periodicity is formed due to a grid arrangement of the protrusion portions (200) and the penetration portions (300), the energy harvesting device (10) may have superior electrical performance in both the low-frequency band and the high-frequency band, as compared to a case in which the body (100) is not formed of a metamaterial.

Referring to FIG. 8a and FIG. 8b, when examining the energy conversion results at the defect portion (P20) in the low-frequency band, at the "first defect mode (BM1) frequency (e.g., 9.430 kHz in the graph)" in the low-frequency band in which the first band gap (B1) is formed, a voltage measurement value (e.g., 1.37 V in the graph) and a maximum power value (e.g., 24.4 µW in the graph) converted and converged by the energy conversion portion (400) may be seen to be increased by approximately 190%, as compared to the case in which the body (100) is not formed of an elastic metamaterial.

Additionally, referring to FIG. 9a and FIG. 9b, when examining an energy conversion result in the defect portion (P20) in the high frequency band, when examining an energy conversion result in the defect portion (P20) in the high frequency band, at the "second defect mode (BM2) frequency (e.g., 47.187 kHz in the graph)" in the high frequency band in which the second band gap (B2) is formed, a voltage measurement value (e.g., 4.05 V in the graph) and a maximum power value (e.g., 1.28 mW in the graph) converted and converged by the energy conversion portion (400) may be confirmed to be increased by approximately 400%, as compared to the case in which the body (100) is not formed of an elastic metamaterial.

As described above, the energy harvesting device (10) according to embodiments of the present invention may form a band gap having an expanded region simultaneously in a low-frequency band and a high-frequency band, by periodically forming a plurality of protrusion portions (200) and a plurality of penetration portions (300) on a body (100) and utilizing local resonance induced by the protrusion portions (200) and Bragg scattering generated by the periodicity of the penetration portions (300). In addition, the energy harvesting performance of the energy harvesting device (10) may be improved by destroying the periodicity of the unit pattern portion (P10) in a partial region of the body (100) to form a defect state, condensing elastic wave energy at the defect portion (P20) and converting the elastic wave energy into electrical energy. Accordingly, the limitations of the high-performance piezoelectric energy harvesting device, which was limited to the high-frequency range, may be overcome, which may make it possible to implement the energy harvesting device (10) in the low-frequency range as well, for application in real life.

Although embodiments of the present invention have been described above with reference to the attached drawings, those skilled in the art will understand that the present invention may be implemented in other specific forms without altering a technical concept or essential features. Therefore, the embodiments described above should be understood as illustrative in all respects and not restrictive.

### Industrial Applicability

The present invention may be applied to industrially available energy harvesting devices.

## Claims

1. An energy harvesting device, comprising:
a body;
a plurality of unit pattern portions formed and arranged periodically on the body, each including a protrusion portion formed to protrude in one direction from a surface of the body, and a penetration portion formed to penetrate the body in the one direction;
a defect portion disposed on the body, and formed in a position adjacent to portions of the plurality of unit pattern portions; and
an energy conversion portion disposed in the defect portion.

2. The energy harvesting device of claim 1, wherein the unit pattern portion has a shape in which, based on the protrusion portion, a plurality of penetration portions surround the protrusion portion but are spaced apart from each other.

3. The energy harvesting device of claim 2, wherein a plurality of the unit pattern portions are arranged in a grid shape on the body.

4. The energy harvesting device of claim 1, wherein the defect portion is surrounded by the plurality of unit pattern portions and is a region in which the protrusion portion is not formed.

5. The energy harvesting device of claim 2, wherein, in the defect portion, a first band gap in a first frequency band is generated by local resonance induced by the protrusion portion, and a second band gap in a second frequency band is generated by periodicity of the penetration portion.

6. The energy harvesting device of claim 5, wherein the second frequency band is a higher frequency band than the first frequency band.

7. The energy harvesting device of claim 5, wherein the first band gap and the second band gap are generated simultaneously.

8. The energy harvesting device of claim 5, wherein, when the band gap is generated, a region of the first band gap and a region of the second band gap are expanded due to interaction between the protrusion portion and the penetration portion.

9. The energy harvesting device of claim 1, wherein the protrusion portion is in the form of a cylindrical projection, and
the penetration portion is in the form of a penetration hole having a circular cross-section.

10. The energy harvesting device of claim 9, wherein the protrusion portion and the penetration portion have the same diameter.

11. The energy harvesting device of claim 1, wherein the energy conversion portion includes a piezoelectric element.

12. The energy harvesting device of claim 1, wherein the body is formed of an elastic metamaterial.
